**Europäisches Patentamt**

**European Patent Office**

**Office européen des brevets**

(19)

(11) Veröffentlichungsnummer: **0 263 154 B1**

(12) **EUROPÄISCHE PATENTSCHRIFT**

(45) Veröffentlichungstag der Patentschrift:
**02.01.92 Patentblatt 92/01**

(21) Anmeldenummer: **87902487.5**

(22) Anmeldetag: **08.04.87**

(86) Internationale Anmeldenummer:
**PCT/EP87/00191**

(87) Internationale Veröffentlichungsnummer:
**WO 87/06352 22.10.87 Gazette 87/23**

(51) Int. Cl.⁵: **G01R 15/02,** G01R 21/08, G01R 15/12

(54) **MULTIFUNKTIONSMESSGERÄT.**

Die Akte enthält technische Angaben, die nach dem Eingang der Anmeldung eingereicht wurden und die nicht in dieser Patentschrift enthalten sind.

(30) Priorität: **09.04.86 DE 3611855**

(43) Veröffentlichungstag der Anmeldung:
**13.04.88 Patentblatt 88/15**

(45) Bekanntmachung des Hinweises auf die Patenterteilung:
**02.01.92 Patentblatt 92/01**

(84) Benannte Vertragsstaaten:
**BE DE FR GB IT**

(56) Entgegenhaltungen:
**DE-A- 2 409 247
DE-A- 3 323 961
FR-A- 2 381 317
US-A- 2 886 779
US-A-45 146 85**

(56) Entgegenhaltungen:
**Elektronik, Band 25, 16 Dezember 1983, Franzis-Verlag GmbH, (München, DE),
"Stromzange misst lageunabhängig", Seite 104
JEE, Journal of Electronic Engineering, Nr. 129, September 1977, Dempa publications Inc., (Tokyo, JP), "Clamp-on meters - ideal measuring instruments for electrical systems", pages 26-27**

(73) Patentinhaber: **Müller und Weigert GmbH
Postfach 3042 Kleinreuther Weg 88
8500 Nürnberg 10 (DE)**

(72) Erfinder: **HOLSTEIN, Jörg
Peyerstr. 30
W-8500 Nürnberg (DE)**
Erfinder: **RAPP, Lothar
Hornschuchpromenade 19
W-8510 Fürth (DE)**

(74) Vertreter: **Dreiss, Uwe, Dr. jur. Dipl.-Ing. M.Sc. et al
Patentanwälte Dreiss, Hosenthien & Fuhlendorf Gerokstrasse 6
W-7000 Stuttgart 1 (DE)**

## Beschreibung

Die Erfindung betrifft ein multifunktionales Meßgerät zum Messen elektrischer Größen aus dem Bereich der Elektroanlagentechnik. Als wesentlicher Meßgeber dient eine hallsensorbestückte Anlegezange, die den jeweils zu messenden Stromleiter zur Gleich- oder Wechselstrommessung umfaßt. Der Gesamtmeßbereich ist dabei in mindestens zwei umschaltbare Meßbereiche aufgeteilt, vgl. den Oberbegriff des Anspruchs 1.

Ein derartiges Meßgerät ist in "Elektronik", Nr. 25, 16. Dezember 1983, Seite 104 beschrieben. Die Anlegezange ist dabei ein eigener Meßgeber, der mit dem Anzeigeinstrument durch Kabel verbunden ist. Ferner ist in der EP-A 67 527 ein mit zwei Hallsensoren bestücktes Zangenanlegemeßgerät beschrieben, das als einstückiges Meßgerät mit digitaler Meßwertanzeige ausgeführt ist und durch einen besonderen Öffnungsmechanismus der Zangen besonders für die Messung von Gleichströmen geeignet ist.

Derartige Zangenanlegemeßgeräte sind in der Elektroanlagenmeßtechnik weit verbreitet, weil sie bekanntlich eine Strommessung ohne Auftrennung oder Abisolierung des Leiters, also während des normalen Betriebs erlauben.

Nachteilig bei derartigen Zangenanlegemeßgeräten ist, daß ihre Meßgenauigkeit zu wünschen übrig läßt. Zudem sind für die Gleich- oder Wechselstrommessungen meist unterschiedliche Zangenanlegemeßgeräte erforderlich, wobei solche, die mit Hallsensoren bestückt sind, wie oben gezeigt, für die Messung des Gleich- und Wechselstroms einrichtbar sind. Es gibt auch Zangen-Leistungsmesser, denen zur Leistungsmessung zusätzlich die am Verbraucher abgegriffene Spannung zugeführt ist.

Die Genauigkeit der Messung leidet auch meist darunter, daß der angezeigte Meßwert von der Kurvenform abhängig ist, also keiner echten Effektivwertmessung entspricht.

Aus der FR-A-2 381 317 ist es bekannt, bei einem elektronischen kWh-Meßgerät die gemessenen Strom- und Spannungswerte zusammen mit gespeicherten Korrekturwerten aus einer der eigentlichen Messung zeitlich vorangehenden Abgleichmessung aufzubereiten. Hierzu ist vorgesehen, daß in geeignet festgelegten Zeitabständen an die Eingangklemmen des Meßgeräts jeweils ein Nullpotential und eine fest vorgegebene Referenzgröße angelegt werden. Die Kalibration des kWh-Meßgeräts wird dann über die Abweichung der gemessenen Größen von ihren vorgegebenen Standardwerten durchgeführt.

Aus der DE-A-3 323 961 ist eine Meßeinrichtung für Wechselstromgrößen bekannt. In einem Meßwertaufnehmer, der einen Hallsensor enthält, wird abwechselnd ein Signal erzeugt, aus dem die Wirkleistung bzw. die Blindleistung eines Wechselstromverbrauchers oder -erzeugers ermittelt wird. Ein Microprozessor erhält die in einem integrierenden Analog/Digitalwandler digitalisierten und über eine Anzahl halber Wechselstromperioden gemittelten Wirk- und Blindleistungsmeßwerte sowie ein Spannungssignal zugeführt und berechnet daraus alle übrigen elektrischen Größen des Wechselstromverbrauchers oder -erzeugers.

Aus der DE-A-2 409 247 ist eine Strommeßeinrichtung bekannt, die eine Strommeßzange zur magnetischen Messung von Wechsel- und pulsierenden Gleichströmen aufweist. Aus dieser Druckschrift ist es weiterhin bekannt, daß in einem Funktionsbaustein der Strommeßeinrichtung ein arithmetischer Mittelwert oder ein Effektivwert des zu messenden Stroms gebildet und zur Anzeige gebracht wird.

Aus der Druckschrift JEE, Journal of Electronic Engineering, Nr. 129, 1977, S. 26 u. 27 ist es bekannt, bei einem eine Strommeßzange einsetzenden Meßgerät automatisch dann Meßbereichsumschaltungen vorzunehmen, sobald beim Meßvorgang eine Bereichsüberschreitung erkannt wird.

Es ist Aufgabe der in Anspruch 1 definierten Erfindung, das eingangs beschriebene multifunktionaleMeßgerät so weiterzubilden, daß es bei verbesserter Genauigkeit die Messung von signalformunabhängigen Strom- , Spannungs-, Leistung- und Frequenzwerten erlaubt.

Diese Aufgabe wird durch die im Kennzeichen des Anspruchs 1 enthaltenden Merkmale gelöst.

Bevorzugte Ausführungsbeispiele ergeben sich aus den Unteransprüchen.

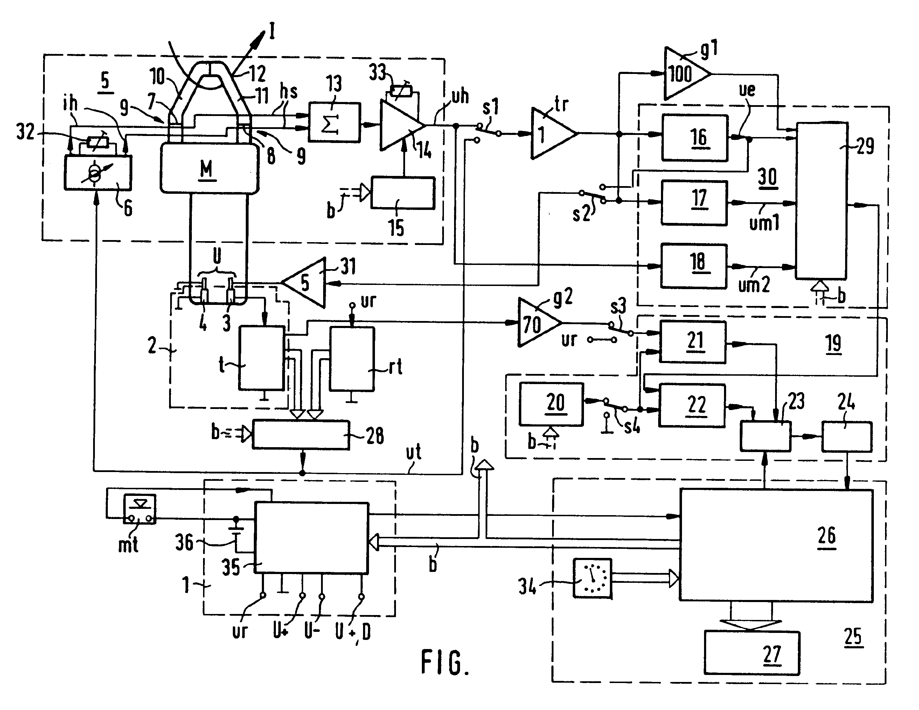

Die Erfindung wird nun anhand der Figur der Zeichnung näher erläutert, die schematisch als Blockschaltbild ein Ausführungsbeispiel der Gesamtschaltung des multifunktionalen Meßgeräts zeigt.

Im Blockschaltbild nach der Figur ist das Gehäuse M des multifunktionalen Meßgeräts mit den beiden Schenkeln 10, 11 der Anlegezange 12 dargestellt. Diese umfaßt einen Stromleiter, der den Strom I führt. Die weiter in der Figur gezeigten Schaltungsteile sind auf einzelnen Platinen untergebracht, die im Gehäuse M montiert sind. In das Gehäuse M eingelassen und von außen zugänglich ist die LCD-Anzeige 27, die Meßtaste mt, der Funktionswahlschalter 34, der von außen zugängliche Schalthebel des zweiten Umschalters s2 und die Ein/Ausgangs-Kombinationsbuchsen 3,4, die einmal der Zuführung der zu messenden Spannung U dienen, zum anderen aber auch über einen speziellen Stecker eine interne Meßspannung zu Registrierzwecken von außen zugänglich macht, z.B. zur Registrierung von I.

In den beiden Schenkeln 10, 11 der Anlegezange 12 befindet sich jeweils in einem Spalt 9 ein Hallsensor 7, 8, deren zugehörige Hallströme ih mittels der Konstantstromquelle 6 erzeugt sind. Der Betrag und die Richtung der beiden Hallströme ih wird durch eine an die Konstantstromquelle 6 angelegte Steuerspannung bestimmt. Das Verhältnis der durch die beiden Hallsensoren 7, 8 fließenden Hallströme ist durch die erste Einstelleinrichtung 32 veränderbar. Damit werden vom Hersteller Ungleichheiten der beiden Hallsensoren 7, 8 und Ungleichheiten der beiden Schenkel 10, 11 ausgeglichen. Die Ausgangsspannung der beiden Hallsensoren 7, 8, die beiden Hallsensorspannungen hs, werden vom Summierer 13 addiert. Dessen Ausgangssignal wird vom einstellbaren Verstärker 14 verstärkt, dessen Ausgangssignal auch das des Hallmeßkreises 5 ist, nämlich die Hallspannung uh. Der Hallmeßkreis 5 umfaßt dabei die eben beschriebenen Schaltungsteile.

Mit der zweiten Einstelleinrichtung 33 ist der einstellbare Verstärker 14 in seiner Verstärkung veränderbar. Mit ihm und mit einem geeigneten Eichstrom wird beim Hersteller der Strommeßwert auf die Anzeige eingeeicht.

Der Spannungsmeßkreis 2 stellt einen weiteren Meßkreis dar, der im wesentlichen aus dem Eingangsspannungsteiler t besteht, der mit seinem einen Ende an der Ein/Ausgangskombinationsbuchse 3 und mit seinem anderen Ende an Masse liegt. Die verschiedenen Spannungsabgriffe dieses Eingangsspannungsteilers sind aus dem Spannungsmeßkreis 2 herausgeführt.

Einen weiteren Block aus zusammengehörigen Schaltungsteilen bildet der Funktionswandler 30. Er enthält den Effektivwertbildner 16, den ersten und den zweiten Mittelwertbildner 17, 18 und den ersten elektronischen Umschalter 29. Innerhalb des Funktionswandlers 30 ist der Ausgang des Effektivwertbildners 16 sowie der des ersten und zweiten Mittelwertbildners 17, 18 jeweils mit einem Eingang des ersten elektronischen Umschalters 29 verbunden, dessen Ausgang an einem Eingang des Digitalisierungsteils 19 liegt.

Die Eingangssignale des Funktionswandlers 30 sind das Eingangssignal des Etfektivwertbildners 16 sowie das des ersten und des zweiten Mittelwertbildners 17, 18. Der Eingang des Effektivwertbildners 16 und der des ersten Mittelwertbildners 17 sind miteinander verbunden und liegen ferner am Eingang des ersten Verstärkers g1, dessen Ausgangssignal einem weiteren Eingang des ersten elektronischen Umschalters 29 zugeführt ist, wobei der Verstärkungsfaktor vorzugsweise gleich 100 ist.

Die elektrische Verbindung zwischen dem Hallmeßkreis 5 und dem Funktionswandler 30 erfolgt zum einen durch die feste Verbindung zwischen dem Ausgang des Hallmeßkreises 5 und dem Eingang des zweiten Mittelwertbildners 18 und zum anderen durch die zuschaltbare Verbindung über den ersten Schaltkontakt des ersten Umschalters s1, auf den Eingang des Impedanzwandlers tr und von dessen Ausgang auf die zusammengeschalteten Eingänge des ersten Verstärkers g1, des Effektivwertbildners 16 und des ersten Mittelwertbildners 17.

Die Spannungsabgriffe des Eingangsspannungsteilers t sind mit jeweils einem Eingang des zweiten elektronischen Vielfachumschälters 28 verbunden. Der von einer Ausgangsspannung des Netzteils 1, nämlich der Referenzspannung ur, gespeiste Referenzspannungsteiler rt, dessen andere Seite mit Masse verbunden ist, ist mit seinen Spannungsabgriffen ebenfalls jeweils mit einem freien Eingang des zweiten elektronischen Vielfachumschalters 28 verbunden. Je nach dessen Schalterstellung wird nun ein unterschiedlich hohes U-abhängiges Spannungssignal oder ein unterschiedlich hohes festes Spannungssignal am Ausgang des zweiten elektronischen Vielfachumschalters 28 abgegeben, der mit dem Steuereingang der Konstantstromquelle 6 und mit dem zweiten Eingang des ersten Umschalters s1 verbunden ist.

Der Hallstrom ih ist damit für die verschiedenen Strommeßbereiche ein vorwählbarer konstanter Wert.

Für die Wirkleistungsmessung Pw ist der Hallstrom ih indessen direkt proportional zum Momentanwert der zugeführten Spannung U, unabhängig davon, ob es sich dabei um eine Gleich-, eine Wechsel- oder eine verzerrte Spannung handelt. Die verschiedenen Abgriffe des Eingangsspannungsteilers t ermöglichen auch bei der Wirkleistungsmessung die Bereichsumschaltung.

Die Messung des zugeführten Gleich- oder Wechselstromes I erfolgt bekanntlich aus der physikalischen Eigenschaft der Hallsensoren, daß deren abgegebene Hallsensorspannung hs proportional zum Momentanwert des Hallstromes ih und zum Momentanwert des magnetischen Flusses ist, der wiederum proportional zum von der Zangeneinrichtung 12 umfaßten momentanen Strom I ist. Ist durch geeignete Maßnahmen, z.B. mittels des Eingangsspannungsteilers t, der Hallstrom ih proportional zu der am Verbraucher abfallenden Spannung, nämlich zu der zugeführten Spannung U, gemacht, dann ist die abgegebene Hallsensorspannung hs proportional zur momentan vom Verbraucher aufgenommenen Wirkleistung Pw. Diese liegt somit als eine Momentanwertgröße in Form der Hallsensorspannung hs für die weitere Signalverarbeitung vor.

Die Umwandlung des bei der Strom- und Spannungsmessung vorliegenden Momentanwerts erfolgt im Effektivwertbildner 16, dem als Eingangssignal wie beschrieben entweder die Hallspannung uh oder die Ausgangsspannung des zweiten elektronischen Vielfachumschalters 28, nämlich die geteilte Spannung ut zugeführt ist. Bei der Strommessung kann zudem das Ausgangssignal des Effektivwertbildners 16 über den von außen einstellbaren zweiten Umschalter s2 und den Trennverstärker 31, dessen Verstärkung beispielsweise 5 beträgt, der Ein/Ausgangs-Kombinationsbuchse 3 zugeführt werden. In der anderen Stellung des zweiten Umschalters s2 wird statt des Ausgangs des Effektivwertbildners 16 sein Eingang angeschlossen, so daß das an der Ein/Ausgangs-Kombinationsbuchse 3 abgegriffene Meßsignal proportional zum Momentanwert des

EP 0 263 154 B1

zugeführten Stromes I ist.

Die Digitalisierung der Ausgangssignale des ersten elektronischen Vielfachumschalters 29 erfolgt im Digitalisierungsteil 19, das den Single-Slope-Generator 20, den ersten und den zweiten Komparator 21, 22, die Logikschaltung 23, den Taktgenerator 24 sowie den dritten und den vierten Umschalter s3, s4 enthält. Außer der A/D-Wandlung dient der Digitalisierungsteil 19 der Bestimmung von Zeitdifferenzen, wie sie bei der Messung der Frequenz f und des Leistungsfaktors $\cos\phi$ auftreten.

Die Digitalisierung von Analogwerten erfolgt im wesentlichen dadurch, daß der Single-Slope-Generator 20 über den vierten Umschalter s4 bzw. das Ausgangssignal des ersten elektronischen Umschalters 29 auf einen Referenz- bzw. Meßeingang des zweiten Komparators 22 geschaltet ist, dessen Ausgang mit einem Eingang der Logikschaltung 23 verbunden ist. Der Referenz- bzw. Meßeingang des ersten Komparators 21 ist dabei über den vierten Umschalter s4 auf den Ausgang des Single-Slope-Generators 20 bzw. über den dritten Umschalter s3 auf die Referenzspannung ur geschaltet, und der Ausgang ist mit dem anderen Eingang der Logikschaltung 23 verbunden. Die Startspannung des Single-Slope-Generators 20 ist größer als die Referenzspannung ur und bei deren Erreichen kippt das Ausgangssignal des ersten Komparators 21, der am Ausgang der Logikschaltung 23 einen dem Taktgenerator 24 zugeführten Torimpuls erzeugt. Erreicht die Single-Slope-Generator-Ausgangsspannung bei ihrem zeitlinearen Abfall einen Pegel, der gleich dem des Ausgangssignals des ersten elektronischen Vielfachumschalters 29 ist, dann kippt der zweite Komparator 22 in den anderen Zustand und beendet über die Logikschaltung 23 den Torimpuls. Während der Dauer des Torimpulses gibt der Taktgenerator 24 Zählsignale an den Zählereingang des Mikroprozessors 26; die Frequenz beträgt z.B. 300 kHz.

Die Frequenzmessung erfolgt über die Messung der Periodendauer T, und diese wird aus dem Zeitabstand zweier gleichsinniger Nulldurchgänge eines zum Wechselstrom I oder zur Wechselspannung U proportionalen Meßsignals im Digitalisierungsteil 19 bestimmt. In der Figur ist das beispielsweise durch die Schalterstellung des 3. Umschalters s3 für die zugeführte Spannung U gezeigt. Um die Nulldurchgänge der geteilten Spannung ut sicher zu erfassen, wird diese von einem relativ hohen Abgriff des Eingangsspannungsteilers t abgenommen und zusätzlich mittels des zweiten Verstärkers g2, dessen Vetstärkungsfaktor beispielsweise 70 beträgt, weiter verstätkt. Damit ist aus der geteilten Spannung ut nahezu ein Rechtecksignal mit steilen Flanken geworden, das über den einen Eingang des dritten Umschalters s3 auf den Meßeingang des ersten Komparators 21 geschaltet ist. In der anderen Stellung des dritten Umschalters s3 ist die Referenzspannung ur an den Meßeingang angeschlossen. Der Referenzeingang liegt dabei über den vierten Umschalter s4 an Masse; in dessen anderer Schalterstellung ist der Single-Slope-Generator 20 wie beschrieben an den Eingang des zweiten Komparators 22 angeschlossen. Das Ausgangssignal des ersten Komparators 21 erzeugt zusammen mit der Logikschaltung 23, die z.B. in diesem Fall ein Binärteiler sein kann, ein Torsignal mit der zeitlichen Länge T der Eingangswechselspannungs-Periode, das während seiner Dauer Zählimpulse des Taktgenerators 24 auf den Zählereingang des Mikroprozessors 26 schaltet.

Für die Leistungsfaktormessung $\cos\phi$ muß außer der Messung der Periodendauer T der zeitliche Abstand dt zwischen dem gleichsinnigen Nulldurchgang des Wechselstromes I und dem dazu gleichsinnigen Nulldurchgang der Wechselspannung U gemessen werden. Hierzu wird die Hallspannung uh mittels des ersten Verstärkers g1 in ein steilflankiges rechteckförmiges Signal umgewandelt, das als Ausgangssignal des ersten elektronischen Umschalters 29 dem Meßeingang des zweiten Komparators 22 zugeführt ist.

Wie bei Frequenzmessung beschrieben, ist das zur Wechselspannung U proportionale Ausgangssignal des zweiten Verstärkers g2 dem Meßeingang des ersten Komparators 21 zugeführt. Der Referenzeingang des ersten und des zweiten Komparators 21, 22 liegt dabei über den vierten Umschalter s4 an Masse. Hier erzeugt nun die Logikschaltung 23 einen Torimpuls, dessen Dauer proportional zum zeitlichen Abstand dt ist, und bestimmt damit die Zahl der dem Mikroprozessor 26 zugeführten Zählimpulse.

Das unterschiedliche Verhalten der Logikschaltung 23 beim Bestimmen des zeitlichen Abstandes dt und der Periodendauer T ist mittels eines Steuersignals vom Mikroprozessor 26 gesteuert, der ferner über den Steuerbus B die jeweilige Schalterstellung des ersten bzw. des zweiten elektronischen Umschalters 28, 29 steuert sowie den Single-Slope-Generator 20 und den Mehrfachspannungserzeuger 35 im Netzteil 1 in Betrieb setzt. Ferner sind der erste, der dritte und der vierte Umschalter ebenfalls vom Mikroprozessor 26 gesteuert. Dem in der Figur angegebenen Digitalteil 25 ist der Mikroprozessor 26, die von ihm direkt angesteuerte LCD-Anzeige 27, und der Funktionswahlschalter 34 zururechnen, dessen Ausgänge mit jeweils einem Eingangsanschluß des Mikroprozessors 26 verbunden sind.

Im Netzteil 1 speist die Batterie 36 den Mehrfachspannungsgenerator 35, der die Referenzspannung ur, die negative und die positive Versorgungsspannung U-und U+, ferner das Massepotential und für die Display-Anzeige die weitere positive Versorgungsspannung U+,D abgibt. Der eine Pol der Batterie 36 ist über die Meßtaste mt mit dem Mehrfachspannungsgenerator 35 verbunden, um diesen über einen Tastendruck starten zu lassen. Ferner ist eine Signalleitung von der Meßtaste mt über den Mehrfachspannungsgenerator 35 mit einem

4

Eingangsanschluß des Mikroprozessors 26 verbunden, die z.B. 5 V an diesen durchschaltet, solange die Meßtaste mt gedrückt ist.

Über den Steuerbus b trennt der Mikroprozessor 26 nach einer vorgegebenen Zeit, in der die Meßtaste mt nicht mehr betätigt wurde, das Netzteil 1 von der Batterie 36 vollständig ab. Um Strom zu sparen wird zudem nach dem eigentlichen Meßvorgang sofort die Stromversorgung für den Meß- und Signalverarbeitungsteil abgeschaltet und mittels der positiven Versorgungsspannung U+,D nur ein "Display-hold"-Betrieb aufrechterhalten, dessen Stromverbrauch gering ist.

Das erstmalige Drücken der Meßtaste mt löst einen Power-On-Reset aus, der eine vom Mikroprozessor 26 gesteuerte Abgleichroutine in Gang setzt. Hier wird die erste Offsetspannung u1 des Hallmeßkreises bestimmt, indem ohne zu messenden Strom I der Hallstrom ih auf null eingestellt und dann die Hallspannung uh gemessen wird. Dies ist der erste durch Abgleich zu bestimmende Korrekturwert, der in den Speicherteil des Mikroprozessors 26 übernommen wird. In der Figur enthält der Hallmeßkreis 5 die vom Mikroprozessor 26 gesteuerte Nullabgleichsschaltung 15, deren Ausgang zum Nullabgleich auf den einstellbaren Verstärker 14 geschaltet ist. Über den Mikroprozessor 26 und die Nullabgleichsschaltung 15 besteht somit ein Regelkreis, der die erste Offsetspannung u1 auf null regelt. Die Nullabgleichsschaltung 15 kann z.B. ein Digitalanalogwandler sein, dessen Ausgangsspannung mit der Eingangsspannung des einstellbaren Verstärkers 14 über einen Widerstand verbunden ist.

Ein zweiter durch Abgleich zu bestimmender Korrekturwert, nämlich der Proportionalitätsfaktor p, ergibt sich daraus, daß selbst bei abgeglichener erster Offsetspannung u1 die Hallspannung uh nicht abgeglichen bleibt, wenn der Hallstrom ih zugeschaltet wird, und zwar ist die entstehende Nullabweichung der Hallspannung uh proportional zum jeweils eingestellten Hallstrom ih, dabei darf natürlich kein zu messender Strom I fließen. Der Proportionalitätsfaktor p wird somit aus der Nullpunktabweichung der Hallspannung uh bei zwei unterschiedlichen Hallströmen ih1, ih2 als zweiter abzuspeichernder Korrekturwert bestimmt.

Ein dritter durch Abgleich zu bestimmender Korrekturwert, der ebenfalls abgespeichert wird, ist die zweite Offsetspannung u2 des Effektivwertbildners 16. Zu deren Messung wird über den zweiten elektronischen Umschalter 28 oder über einen in der Figur nicht gezeichneten weiteren Umschalter der Eingang des Effektivwertbildners auf Masse gelegt und die zugehörige Effektivwertspannung ue am Ausgang gemessen.

Der vierte bzw. fünfte durch Abgleich zu bestimmende Korrekturwert ist die dritte bzw. vierte Ofset-spannung u3, u4 des ersten bzw. zweiten Mittelwertbildners 17, 18. Der Eingang des ersten Mittelwertbildners 17 ist wie eben beschrieben zusammen mit dem Effektivwertbildner 16 auf Masse gelegt, während der zweite Mittelwertbildner 18 am Ausgang des auf null abgeglichenen einstellbaren Verstärkers 14 liegt. Das gemessene erste bzw. zweite Mittelwertsignal um1, um2 ist die abzuspeichernde dritte bzw. vierte Offsetspannung u3, u4. Die Mittelwertbildner 17, 18 können z.B. aktive RC-Filterschaltungen enthalten.

Der sechste durch Abgleich zu bestimmende und abzuspeichernde Korrekturwert ist der in der Nähe von eins liegende Verstärkungsfaktor v des Effektivwertbildners 16. Er wird aus dem Effektivwertsignal ue bestimmt, wenn dem Eingang des Effektivwertbildners 16 über den ersten Umschalter s1 und den zweiten elektronischen Vielfachumschalter 28 eine definierte Referenzspannung zugeführt ist.

Neben den Korrekturwerten sind im Speicherteil des Mikroprozessors 26 schaltungsbedingte Konstanten vom Hersteller bereits abspeicherbar:

Die erste Konstante ist die Steilheit c1 des Hallmeßkreises 5, die angibt, wie bei einem festen Hallstrom ih sich die Hallspannung uh in Abhängigkeit vom zu messenden Strom I ändert;

die zweite schaltungsbedingte konstante ist die Hallstrom-Steilheit c2, die angibt, wie der Hallstrom ih von der Eingangsspannung der konstantstromquelle 6, also der geteilten Spannung ut, abhängig ist;

die dritte schaltungsbedingte konstante ist der Teilungsfaktor k, der durch das vom jeweiligen Meßbereich abhängige Teilungsverhältnis zwischen der geteilten Spannung ut und der zugeführten Spannung U bestimmt ist;

die vierte konstante ist der Wert des innerhalb eines Strommeßbereichs fest eingestellten Hallstroms ih.

Für die angezeigten Meßwerte gelten nun folgende Bemessungsregeln:

Für den zu messenden Strom I, wobei dem Effektivwertbildner 16 als Eingangssignal die Hallspannung uh zugeführt ist:

$$I = ( (ue-u2)v^{-1}-p \cdot ih-u1 ) (c1)^{-1} (ih)^{-1};$$

für die zu messende Spannung U, wobei das Eingangssignal des Effektivwertbildners 16 die geteilte Spannung ut und das Ausgangssignal das Effektivwertsignal ue' ist:

$$U = (ue' - u2)(kv)^{-1};$$

für die zu messende Scheinleistung Ps:

$$Ps = (ue'-u2)((ue-u2)v^{-1}-p \cdot ih-u1)(kvih)^{-1}(c1)^{-1},$$

wobei das spannungsbezogene Effektivwertsignal ue' und das strombezogene Effektivwertsignal ue zeitlich

EP 0 263 154 B1

nacheinander bestimmt werden;

für die zu messende Wirkleistung Pw, wobei dem ersten Mittelwertbildner 17 an seinem Eingang die geteilte Spannung ut und dem zweiten Mittelwertbildner 18 an seinem Eingang die Hallspannung uh zugeführt ist:

$$Pw = (um2-(pc2)(um1-u3)-u1-u4)(kc1)^{-1}(c2)^{-1};$$

für die zu messende Frequenz f:

$$f = 1/T; \text{ und}$$

für den zu messenden Leistungsfaktor $\cos\phi$:

$$\cos\phi = \cos(2\,\pi\,fdt).$$

Dabei ist $\pi$ das bekannte Verhältnis von Umfang zu Durchmesser des Einheitskreises. Die angegebenen Bemessungsregeln für die anzuzeigenden Werte vereinfachen sich, wenn einzelne korrekturwerte durch ein Abgleichverfahren auf ihren Sollwert gebracht sind, wie dies beispielsweise mittels der Nullabgleichsschaltung 15 bei der ersten Offsetspannung u1 erreicht ist.

Die Ermittlung der verschiedenen angezeigten Meßgrößen aus den angegebenen Bemessungsregeln erweist sich als äußerst vorteilhaft, weil mit einem einzigen Meßinstrument wesentliche Meßgrößen aus der Elektroanlagentechnik genau erfaßt werden können. Durch den elektronischen Vorabgleich, der auch während des Betriebes durch ein spezielles Bedienen der Meßtaste mt laufend wiederholt werden kann, erübrigt sich ein für den Anwender lästiger manueller Abgleich, der bisher allenfalls auf eine besonders kritische Korrekturgröße beschränkt war. Somit sind auch die üblichen Störgrößen ohne Einfluß, wie z.B. die Temperatur, die Drift einzelner Bauelemente oder deren Alterung. Aber auch Störgrößen, die sich aus dem Restmagnetismus in der Anlegezange 12 ergeben, der bei der Messung eines großen Stromes I entstanden sein kann und ohne Kompensation die nachfolgenden Messungen stören würde, werden so ausgeschaltet.

Ein weiterer Vorteil ist die Anordnung der Anlegezange 12 mit zwei Hallsensoren 7, 8, deren Hallsensorspannungen auf den Summierer 13 geschaltet sind. Durch diese Anordnung, auch in Verbindung mit der Einstellung des Hallstromverhältnisses, ist der angezeigte Meßwert beinahe unabhängig von der Lage des umfaßten Stromleiters.

Ein sehr praktischer Vorteil der digitalen Signalaufbereitung ist, daß auch an unzugänglichen Stellen gemessen werden kann, weil die angezeigten Werte im Mikroprozessor 26 gespeichert sind. Von Vorteil ist ferner, daß mittels der LCD-Anzeige 27 angegeben ist, ob es sich bei dem Meßwert um eine Gleich- oder Wechselgröße handelt und wie die Polarität der Gleichgrößen und die Energieflußrichtung ist.

Mit einem entsprechend der Erfindung realisierten Meßgerät ist die Messung folgender durch einen Drehschalter einstellbarer Meßgrößen möglich:

a) Strommessungen mit automatischer Bereichsumschaltung 200 A/1000 A

b) Maximalwertmessung im Meßbereich 200 A

c) Maximalwertmessung im Meßbereich 1000 A

d) Spannungsmessung mit automatischer Bereichsumschaltung 200 V/750 V

e) Wirkleistungsmessung mit automatischer Bereichsumschaltung 20 KW/200 KW

f) Scheinleistungsmessung mit automatischer Bereichsumschaltung 20 kVA/200 kVA

g) Frequenzmessung mit automatischer Bereichsumschaltung 200 Hz/1000 Hz

h) $\cos\phi$ -Messung

Die hierzu benötigte ElektroniK ist z.B. auf drei Platinen untergebracht. Der größte Teil der Schaltung dient zur analogen Aufbereitung und Weiterverarbeitung der Meßgrößen; der maskenprogrammierte Mikroprozessor 26 übernimmt die Erkennung und Steuerung des gewünschten Meßablaufs sowie die Ansteuerung der LCD-Anzeige.

**Patentansprüche**

1. Multifunktionales Meßgerät

– mit einer Anlegezange (12), die mit mindestens einem Hallsensor (7;8) bestückt ist,

– mit einem Hallmeßkreis (5) und mit einer Anzeigeeinrichtung (27) für den von der Anlegezange (12) umfaßten Gleich- oder Wechselstrom I, wobei der angezeigte Meßwert im wesentlichen unabhängig von der Lage des umfaßten Stromleiters ist, und

– mit mindestens zwei umschaltbaren Meßbereichen, **gekennzeichnet durch**:

– einen Spannungsmeßkreis (2), der der Messung einer an zwei Ein/Ausgangs-Kombinationsbuchsen (3,4) als Gleich- oder Wechselgröße zugeführten Spannung U dient,

– einen Mikroprozessor (26), in dem die gemessenen Strom- und Spannungswerte zusammen mit gespeicherten Korrekturwerten aus einer der eigentlichen Messung zeitlich vorausgehenden Ableichmessung

6

und mit schaltungsbedingten, vom Hersteller fest abgespeicherten Konstanten zu angezeigten Effektivwerten des Gleich- oder Wechselstroms I, der Gleich- oder der Wechselspannung U, der Scheinleistung Ps, der Wirkleistung Pw sowie zu numerischen Werten des Leistungsfaktors cos φ oder der Frequenz f aufbereitet werden, wobei die angezeigten Werte von der Kurvenform des zu messenden Stroms I und/oder der zu messenden Spannung U unabhängig sind und wobei Meßbereichsumschaltung durch den Mikroprozessor (26) erfolgt, sobald dieser beim Meßvorgang eine Bereichsüberschreitung erkennt.

2. Multifunktionales Meßgerät nach Anspruch 1, gekennzeichnet durch:
– einen Funktionswandler (30), der mindestens einen Effektivwertbildner (16) zur Abgabe eines Effektivwertsignals ue, mindestens einen ersten und einen zweiten Mittelwertbildner (17,18) zur Abgabe eines ersten bzw. zweiten Mittelwertsignals um1, um2 und einen ersten elektronischen Vielfachumschalter (29) enthält, der die im Funktionswandler (30) aufbereiteten Meßsignale an einen Digitalisierungsteil (19) abgibt,
– eine steuerbare Konstantstromquelle (6) zur Steuerung des jeweils einem der Hallsensoren (7,8) zugeführten Hallstroms ih, deren Steuerspannung bei der Strommessung konstant und aus einer festen Referenzspannung ur abgeleitet ist, und deren Steuerspannung, und damit der Hallstrom ih, bei der Wirk und der Scheinleistungsmessung (Pw,Ps) proportional zum Momentanwert der zugeführten Spannung U ist.

3. Multifunktionales Meßgerät nach Anspruch 2, gekennzeichnet durch folgende Merkmale:
– ein erster durch Abgleich zu bestimmender Korrekturwert der Hallspannung uh ist die Offsetspannung u1, die bei ih=0 und I=0 auftritt,
– ein zweiter durch Abgleich zu bestimmender Korrekturwert der Hallspannung uh ist der Proportionalitätsfaktor p, der bei der zum Hallstrom ih proportionalen Nullpunktabweichung auftritt und aus Messungen der Hallspannung uh bei I=0 sowie bei unterschiedlichen Hallströmen ih1, ih2 ermittelt ist,
– ein dritter durch Abgleich zu bestimmender Korrekturwert ist die Offsetspannung u2 des Effektivwertbildners (16),
– ein vierter bzw. fünfter durch Abgleich zu bestimmender Korrekturwert ist die Offsetspannung u3 bzw. u4 des ersten bzw. zweiten Mittelwertbildners (17,18),
– ein sechster durch Abgleich zu bestimmender Korrekturwert ist der Verstärkungsfaktor v des Effektivwertbildners (16),
– eine erste schaltungsbedingte und abgespeicherte Konstante ist die Steilheit c1 des Hallmeßkreises (5),
– eine zweite schaltungsbedingte und abgespeicherte Konstante ist die Hallstrom-Steilheit c2, die durch das Verhältnis des von der zugeführten Spannung U abhängigen Hallstroms ih zu der mittels eines Spannungsteilers (t) geteilten Spannung ut bestimmt ist,
– eine dritte schaltungsbedingte und abgespeicherte Konstante ist der Teilungsfaktor k, der durch das vom jeweiligen Meßbereich abhängige Teilungsverhältnis von der geteilten Spannung ut zur zugeführten Spannung U bestimmt ist, und
– eine vierte schaltungsbedingte und abgespeicherte Konstante ist der Wert des innerhalb eines Strom-Meßbereichs fest eingestellten Hallstroms ih.

4. Multifunktionales Meßgerät nach Anspruch 3, dadurch gekennzeichnet, daß die angezeigten Werte folgenden Bemessungsregeln gehorchen:
– für den zu messenden Strom I, wobei dem Effektivwertbildner (16) als Eingangssignal der Hallstrom ih zugeführt ist:
$$I = ((ue - u2)v^{-1} - p \cdot ih - u1)(c1)^{-1} (ih)^{-1},$$
– für die zu messende zugeführte Spannung U, wobei das Eingangssignal des Effektivwertbildners (16) die geteilte Spannung ut und das Ausgangssignal des Effektivwertsignal ue' ist:
$$U = (ue' - u2)(kv)^{-1},$$
– für die zu messende Scheinleistung Ps:
$$Ps = (ue' - u2)((ue - u2)v^{-1} - p \cdot ih - u1)(kv \cdot ih)^{-1}(c1)^{-1},$$
– für die zu messende Wirkleistung Pw, wobei dem ersten Mittelwertbildner (17) eingangsseitig die geteilte Spannung ut und dem zweiten Mittelwertbildner (18) eingangsseitig die Hallspannung uh zugeführt ist:
$$Pw = (um2-(pc2)(um1-u3)-u1-u4)(kc1)^{-1}(c2)^{-1}$$
– für die zu messende Frequenz f:
$$f = 1/T,$$
wobei deren Periodendauer T aus der Dauer zwischen zwei gleichsinnigen Nulldurchgängen der geteilten Spannung ut oder der Hallspannung uh mittels eines als Nulldurchgangsdetektor dienenden ersten Komparators (21) derart gemessen ist, daß das Ausgangssignal des Komparators (21) eine ein ertes Torsignal liefernde Logikschaltung (23) speist, und das Torsignal während der genannten Dauer Zählimpulse eines Taktgenerators (24) auf den Mikroprozessor (26) durchschaltet, und
– für den zu messenden Leistungsfaktor cos φ :

7

$$\cos \phi = \cos(2 \pi fdt),$$

– wobei dt der zeitliche Abstand zwischen den gleichsinnigen Nulldurchgängen der Hallspannung uh und der geteilten Spannung ut ist und die geteilte Spannung ut dem ersten (21) und die Hallspannung uh einem zweiten Komparator (22) zugeführt ist, deren Ausgangssignale zur Bestimmung des zeitlichen Abstandes dt auf die Logikschaltung (23) zur Bildung eines zweiten Torsignals geschaltet sind.

5. Multifunktionales Meßgerät nach Anspruch 4, dadurch gekennzeichnet, daß während der Abgleichmessung mindestens einer der zu bestimmenden Korrekturwerte durch eine zugehörige Abgleichschaltung auf seinen Sollwert abgeglichen ist, so daß durch die abgeglichenen Korrekturwerte, insbesondere durch mindestens eine auf null abgeglichene Offsetspannung u1, u2, u3, u4, die Bemessungsregeln vereinfacht sind.

6. Multifunktionales Meßgerät nach Anspruch 5, dadurch gekennzeichnet, daß die Offsetspannung u1 durch eine vom Mikroprozessor (26) gesteuerte Nullabgleichschaltung (15) auf null abgeglichen ist.

7. Multifunktionales Meßgerät nach Anspruch 1, gekennzeichnet durch folgende Merkmale:
– der Hallmeßkreis (5) enthält zwei Hallsensoren (7,8), deren Hallstromverhältnis einstellbar ist, und
– die den beiden Hällsensoren (7,8) zugeordneten Hallsensorspannungen hs sind einem Summierer (13) zugeführt, dessen Ausgangssignal mittels eines einstellbaren Verstärkers (14) verstärkt ist.

8. Multifunktionales Meßgerät nach Anspruch 1, dadurch gekennzeichnet, daß bei der Strommessung das Ausgangssignal des Hallmeßkreises (5) einer der beiden Ein/Ausgangs-Kombinationsbuchsen (3,4) über einen Trennverstärker (31) wahlweise direkt als Momentanwertsignal oder über den Effektivwertbildner (16) als Effektivwertsignal zugeführt ist.

## Claims

1. A multimeter
– comprising a clip (12) which is equipped with at least one Hall sensor (7,8),
– comprising a Hall measuring circuit (5) and a display device (27) for the a.c. or d.c. current I surrounded by the clip (12), the measured value displayed being largely independent of the position of the surrounded conductor, and
– comprising at least two switchable measuring ranges, <u>characterized by</u>:
– a voltage-measuring circuit (2) for measuring a voltage U applied as a d.c. or a.c. magnitude to two input/output combination sockets (3,4),
– a microprocessor (26) in which the measured current and voltage values, together with stored correction values from a balancing measurement temporally preceding the acutal measurement and with constants determined by circuitry, and permanently stored by the manufacturer, are processed to form displayed effective values of the d.c. or a.c. current I, the d.c. or a.c. voltage U, the apparent power Ps and the real power Pw and also to form numerical values of the power factor $\cos \phi$ or the frequency f, the displayed values being independent of the wave shape of current I and/or voltage U to be measured and a switching-over of the measuring range by the microprocessor (26) taking place as soon as the latter recognizes an exceeding of the measuring range during the measuring process.

2. A multimeter as claimed in Claim 1, characterized by
– a function converter (30) which comprises at least one root-mean-square value module (16) for delivering a root-mean-square-value signal, ue, at least a first and a second average-value module (17,18) for delivering a first and second average-value signal um1, um2 respectively and a first electronic multiple switch (29) which passes the measuring signals processed in the function converter (30) to a digitalizing module (19),
– a controllable constant-current source (6) for controlling the Hall current ih passed to one of the Hall sensors (7,8) in each case, whose control voltage is constant and is derived from a fixed reference voltage ur during current measurement and whose control voltage, and hence the Hall current ih, is proportional, during the measurement of real and apparent power (Pw, Ps), to the instantaneous value of the applied voltage U.

3. A multimeter as claimed in Claim 2, characterized by the following features:
– a first correction value of the Hall voltage uh to be determined by balancing is the offset voltage u1 which occurs when ih=0 and I=0,
– a second correction value for the Hall voltage uh to be determined by balancing is the proportionality factor p which occurs upon the zero-point deviation proportional to the Hall current ih and is determined from measurements of the Hall voltage uh with I=0 and with differing Hall currents ih1, ih2,
– a third correction value to be determined by balancing is the offset voltage u2 of the root-mean-square-value module (16),

– a fourth and fifth correction value to be determined by balancing is the offset value u3 and u4 respectively of the first and second average-value modules (17,18),

– a sixth correction value to be determined by balancing is the gain factor v of the root-mean-square-value module (16),

– a first constant determined by circuitry and stored is the slope c1 of the Hall measuring circuit (5),

– a second constant determined by circuitry and stored is the Hall current slope c2, which is determined by the ratio of the Hall current ih dependent on the applied voltage U to the voltage ut divided by a voltage divider (t),

– a third constant determined by circuitry and stored is the division factor k which is determined by the division ratio of the divided voltage ut to the applied voltage U depending on the measuring range in question, and

– a fourth constant determined by circuitry and stored is the value of the Hall current ih permanently set within a current measuring range.

4. A multimeter as claimed in Claim 3, characterized in that the values displayed comply with the following measurement rules:

– for the current to be measured f, when the Hall current ih is applied to the root-mean-square-value module (16) as the input signal:

$$I = ((ue - u2)v^{-1} - p \cdot ih - u1)(c1)^{-1} (ih)^{-1},$$

– for the applied voltage U to be measured, the input signal of the root-mean-square-value module (16) being the divided voltage ut and the output signal being the root-mean-square-value signal ue':

$$U = (ue' - u2)(kv)^{-1},$$

– for the apparent power Ps to be measured:

$$Ps = (ue' - u2)((ue - u2)v^{-1} - p \cdot ih - u1)(kv \cdot ih)^{-1}(c1)^{-1},$$

– for the real power Pw to be measured, the divided voltage ut being applied to the first average-value module (17) on the input side and the Hall voltage uh being applied to the second average-value module (18) on the input side:

$$Pw = (um2-(pc2)(um1-u3)-u1-u4)(kc1)^{-1}(c2)^{-1}$$

– for the frequency f to be measured:

$$f = 1/T,$$

its periodic duration T being measured from the duration between two zero crossings of the divided voltage ut or of the Hall voltage uh in the same direction by means of a first comparator (21) serving as a zero-crossing detector in such a way that the output signal of the comparator (21) feeds a logic circuit (23) delivering a first gate signal and the gate signal switches, during the said period, counting pulses of a clock generator (24) to the microprocessor (26), and

– for the power factor cos $\phi$ to be measured:

$$\cos \phi = \cos(2 \pi fdt),$$

– dt being the time difference between the zero crossings in the same direction of the Hall voltage uh and the divided voltage ut and the divided voltage ut being applied to the first comparator (21) and the Hall voltage uh being applied to a second comparator (22) the output signal of which are switched, in order to determine the time difference dt, to the logic circuit (23) for the formation of a second gate signal.

5. A multimeter as claimed in Claim 4, characterized in that, during the balancing measurement, at least one of the correction values to be determined is balanced to its desired value by an associated balancing circuit so that the measurement rules are simplified by the balanced correction values, especially by at least one offset voltage u1, u2, u3, u4 balanced to zero.

6. A multimeter as claimed in Claim 5, characterized in that the offset voltage u1 is balanced to zero by a zero-balancing circuit (15) controlled by the microprocessor (26).

7. A multimeter as claimed in Claim 1, characterized by the following characteristics:

– the Hall measuring circuit (5) contains two Hall sensors (7,8) whose Hall current ratio is adjustable, and

– the Hall sensor voltages hs assigned to the two Hall sensors (7,8) are applied to a summer (13) whose output signal is amplified by means of a variable-gain amplifier (14).

8. A multimeter as claimed in Claim 1, characterized in that, during the current measurement, the output signal of the Hall measuring circuit (5) is passed to one of the two input/output combination sockets (3,4) via a buffer amplifier (31) optionally either direct as an instantaneous-value signal or via the root-mean-square value module (16) as a root-mean-square-value signal.

## Revendications

1. Multimètre,
 – avec une pince (12) qui est munie d'au moins un capteur à effet Hall (7, 8),
 – avec un circuit de mesure à effet Hall (5) et avec un dispositif d'affichage (27) pour le courant I continu ou alternatif entouré par la pince (12), dans lequel la valeur de mesure affichée est fondamentalement indépendante de la position du conducteur de courant entouré par la pince, et
 – avec au moins deux gammes de mesure commutables, caractérisé par
 – un circuit de mesure de tension (2) qui sert à mesurer comme grandeur continue ou alternative une tension appliquée à deux bornes combinées d'entrée et de sortie (3, 4),
 – un microprocesseur (26) dans lequel sont traitées les valeurs mesurées de tensions et de courant ainsi que des termes correctifs mis en mémoire à partir d'une mesure préalable de tarage et des constantes mises en mémoire de manière fixe par le constructeur, afin d'afficher les valeurs efficaces du courant continu ou alternatif I, de la tension continue ou alternative U, de la puissance apparente Ps, de la puissance active Pw ainsi que la valeur numérique du facteur de puissance $\cos\phi$ ou de la fréquence f, et dans lequel une commutation de gamme de mesure est effectuée par le microprocesseur (26) dès que celui-ci au cours d'une mesure détecte un dépassement de capacité.

2. Multimètre selon la revendication 1, caractérisé par
 – un convertisseur de fonctions (30) qui comporte au moins un générateur de valeurs efficaces (16) pour l'obtention de la valeur efficace du signal ue, au moins un premier et un deuxième générateurs de valeurs moyennes (17, 18) pour l'obtention d'une première ou d'une deuxième valeur moyenne du signal um1, um2 et un premier commutateur électronique multiple (29) qui délivre à un dispositif de numérisation (19) les signaux de mesure traités par le convertisseur de fonctions (30) ;
 – une source de courant constant (6) susceptible d'être commandée afin de commander le courant de Hall ih appliqué éventuellement à un des capteurs à effet Hall (7, 8), dont la tension de commande est dérivée constamment de la mesure du courant et d'une tension fixe de référence ur, et donc dont le courant de Hall ih, lors de la mesure de puissances active et apparente (Pw, Ps), est proportionnel à la valeur instantanée de la tension appliquée U.

3. Multimètre selon la revendication 2, caractérisé en ce que
 – un premier terme correctif de la tension de Hall uh, à déterminer par tarage, est la tension de décalage u1 qui apparaît quand ih=0 et que I=0,
 – un deuxième terme correctif de la tension de Hall uh, à déterminer par tarage, est le facteur de proportionnalité p qui apparaît dans l'écart par rapport au zéro, proportionnel au courant de Hall ih, et qui est obtenu à partir de mesures de la tension de Hall uh pour I=0 et pour deux courants de Hall différents ih1, ih2,
 – un troisième terme correctif, à déterminer par tarage, est la tension de décalage u2 du générateur de valeurs efficaces (16),
 – un quatrième ou un cinquième terme correctif, à déterminer par tarage, sont les tensions de décalage u3 ou u4 du premier ou du deuxième générateur de valeurs moyennes (17, 18) respectivement,
 – un sixième terme correctif, à déterminer par tarage, est le coefficient d'amplification v du générateur de valeurs efficaces (16),
 – une première constante, dépendant des circuits et mise en mémoire, est la pente c1 du circuit de mesure à effet Hall (5),
 – une deuxième constante, dépendant des circuits et mise en mémoire, est la pente c2 du circuit de courant de Hall, qui est déterminée par le rapport entre le courant de Hall ih dépendant de la tension appliquée U et la tension ut divisée au moyen d'un diviseur de tension (t),
 – une troisième constante, dépendant des circuits et mise en mémoire, est le facteur de réduction k, qui est déterminé à partir du rapport, variant pour chaque gamme de mesure, entre la tension divisée ut et la tension appliquée U,
 – une quatrième constante, dépendant des circuits et mise en mémoire, est la valeur du courant de Hall ih ajusté à une valeur fixe à l'intérieur d'une gamme de mesure de courant.

4. Multimètre selon la revendication 3, caractérisé en ce que les valeurs affichées sont obtenues conformément aux règles suivantes :
 – pour le courant à mesurer I, où la tension de Hall uh est amenée au générateur de valeurs efficaces (16) comme tension d'entrée :

$$I = ((ue-u2)v^{-1} - p{\cdot}ih-u1)(c1)^{-1}(ih)^{-1},$$

 – pour la tension à mesurer U, où le signal d'entrée du générateur de valeurs efficaces (16) est la tension divisée ut, et où le signal de sortie est la valeur efficace ue' du signal :

$$U = (ue' - u2)(kv)^{-1},$$

– pour la puissance apparente à mesurer Ps :

$$Ps = (ue' - u2)(ue - u2)v^{-1} - p \cdot ih-u1)(kvih)^{-1} (c1)^{-1}$$

– pour la puissance active à mesurer pw, où la tension divisée ut est appliquée à l'entrée du premier générateur de valeurs moyennes (17) et où la tension de Hall uh est appliquée à l'entrée du deuxième générateur de valeurs moyennes (18) :

$$Pw = (um2-(pc2)(um1-u3)-u1-u4)(kc1)^{-1}(c2)^{-1},$$

– pour la fréquence à mesurer f :

$$f = 1/T,$$

dans lequel cette période T est mesurée à partir de l'intervalle de temps entre deux passages à zéro dans le même sens de la tension divisée ut ou de la tension de Hall uh au moyen d'un premier comparateur (21) servant de détecteur de passage à zéro, de sorte que le signal de sortie du comparateur (21) alimente un circuit logique (23) délivrant un premier signal de déclenchement et que ledit signal de déclenchement pendant ledit intervalle de temps transmette les impulsions de comptage d'un cadenceur (24) au microprocesseur (26),

– pour le facteur de puissance à mesurer cos $\phi$ :

$$\cos \phi = \cos(2\pi fdt),$$

dans lequel dt est l'intervalle de temps entre les passages à zéro de même sens de la tension de Hall uh et de la tension divisée ut et dans lequel la tension divisée ut est appliquée au premier comparateur (21) et la tension de Hall uh à un deuxième comparateur (22), dont les signaux de sortie sont, afin de déterminer l'intervalle de temps dt, transmis au circuit logique (23) afin d'engendrer un deuxième signal de seuil.

5. Multimètre selon la revendication 4, caractérisé en ce que pendant la procédure de tarage au moins un des termes correctifs à déterminer est réglé à sa valeur théorique au moyen d'un circuit de tarage approprié, de sorte que les règles de mesure soient simplifiées grâce aux termes correctifs ajustés, en particulier grâce à au moins une tension de décalage u1, u2, u3 u4, réglée à zéro.

6. Multimètre selon la revendication 5, caractérisé en ce que la tension de décalage u1 est réglée à zéro au moyen d'un circuit de réglage de zéro (15) commandé par le microprocesseur (26).

7. Multimètre selon la revendication 1, caractérisé en ce que

– le circuit de mesure à effet Hall (5) comprend deux capteurs à effet Hall (7, 8) dont le rapport des courants de Hall est ajustable, et

– les tensions de capteur à effet Hall hs appliquées aux deux capteurs à effet Hall (7, 8) sont amenées à un sommateur (13) dont le signal de sortie est amplifié au moyen d'un amplificateur réglable (14).

8. Multimètre selon la revendication 1, caractérisé en ce que lors de la mesure du courant le signal de sortie du circuit de mesure à effet Hall (5) est transmis à une des deux bornes combinées d'entrée et de sortie (3, 4), soit par l'intermédiaire d'un amplificateur de séparation (31) directement comme valeur instantanée de signal, soit par l'intermédiaire d'un générateur de valeurs efficaces (16) comme valeur efficace de signal.

FIG.